# EUROPEAN PATENT APPLICATION

(11) **EP 3 330 931 A1**
(43) Date of publication of application: **06.06.2018**
(21) Application number: 17204959.5
(22) Date of filing: 01.12.2017
(51) Int. Cl.: G07C 9/00

(54) **ADAPTER**

(30) Priority: 02.12.2016 US 201662429577 P
(71) Applicant: TTI (Macao Commercial Offshore) Limited, Macao (MO)
(72) Inventor: Pleasants, Parke, Anderson, South Carolina 29626 (US); McNabb, William, Anderson, South Carolina 29621 (US); Huggins, Mark, Anderson, South Carolina 29621 (US); Preus, Michael, Greenville, South Carolina 29601 (US)
(74) Representative: Dauncey, Mark Peter

(57) **Abstract**

An accessory device system includes a garage door opener, an adapter, and one or more accessory devices whereby the garage door opener has a first accessory device port configured to selectively couple to the one or more accessory devices and the adapter has a second accessory device port configured to selectively couple to the one or more accessory devices. The garage door opener is further configured to provide power to a first accessory device of the one or more accessory devices via the first accessory device port. The adapter further includes a battery receiving portion configured to be selectively coupled to a battery pack and to receive power from the battery pack, and the adapter is further configured to provide power, received from the battery pack, to the first accessory device via the second accessory device port.

## Description

### CROSS-REFERENCE TO RELATED APPLICATIONS

This application claims priority to co-pending U.S. Provisional Patent Application No. 62/429,577 filed on December 2, 2016, the entire content of which is incorporated herein by reference.

### FIELD OF THE INVENTION

The present invention relates to an adapter for a battery pack and an accessory device.

### SUMMARY OF THE INVENTION

The present invention provides, in one aspect, an accessory device system including an accessory device, a garage door opener including a first accessory device port configured to couple to the accessory device and provide power to the accessory device via the first accessory device port, and an adapter. The adapter includes a second accessory device port configured to couple to the accessory device, and a battery receiving portion configured to be selectively coupled to a battery pack and to receive power from the battery pack. The adapter is configured to provide power, received from the battery pack, to the first accessory device via the second accessory device port.

The present invention provides, in another aspect, a method of operating an accessory device system including a garage door opener, an adapter, and one or more accessory devices. The method includes receiving, by a first accessory device port on the garage door opener, the accessory device. The garage door opener then provides power to the accessory device via the first accessory device port. The first accessory device port then disconnects from the accessory device, and the accessory device is received by a second accessory device port on the adapter. The adapter then provides power to the accessory device via the second accessory device port.

The present invention provides, in another aspect, a method of operating an accessory device system including an adapter and an accessory device. The method includes receiving, by an accessory device port on the adapter, the accessory device and receiving, by a battery receiving portion of the adapter, a battery pack. The adapter then provides, via the accessory device port, power to the accessory device received from the battery pack via the battery receiving portion. The adapter further receives, via the accessory device port, identity and status data from the accessory device. An electronic controller of the adapter having a wireless transceiver then sends the identity and status data regarding the accessory device to the peripheral device. The electronic controller further receives settings data regarding the accessory device from the peripheral device, and the adapter provides the settings data to the accessory device to control the accessory device.

Another aspect provides an accessory device system comprising: an accessory device; a garage door opener including a first accessory device port configured to selectively couple to the accessory device and provide power to the accessory device via the first accessory device port; and an adapter including a second accessory device port configured to selectively couple to the accessory device, and a battery receiving portion configured to be selectively coupled to a battery pack and to receive power from the battery pack; wherein the adapter is configured to provide power, received from the battery pack, to the accessory device via the second accessory device port.

The accessory device may be at least one selected from the group consisting of a wireless speaker, a fan, or a light.

The battery pack may be a power tool battery pack including: battery cells, a second electronic controller having an electronic processor and a memory, and a fuel gauge.

The accessory device may be configured to communicate with a peripheral device via the adapter. The adapter may include a wireless transceiver and may be configured to: communicate with the peripheral device to provide identity and status information regarding the accessory device to the peripheral device, receive settings data from the peripheral device to control the first accessory device, receive the identity and status information from the first accessory device, and provide the settings data to the accessory device to control the accessory device.

In the accessory device system: (i) the accessory device is configured to communicate with a peripheral device via the garage door opener; or (ii) the accessory device is a first accessory device, and the system further comprises a second accessory device, the second accessory device configured to selectively couple to the first accessory device port and to the second accessory device port.

The second accessory device port may include a communication interface configured to facilitate electrical communication between the accessory device and the adapter, and a coupling interface configured to mechanically couple the accessory device and the adapter.

Another aspect provides a method of operating an accessory device system including a garage door opener, an adapter, and one or more accessory devices, the method comprising: receiving, by a first accessory device port on the garage door opener, the accessory device; providing, by the garage door opener, power to the accessory device via the first accessory device port; disconnecting, by the first accessory device port, from the accessory device; receiving, by a second accessory device port on the adapter, the accessory device; and providing, by the adapter, power to the accessory device via the second accessory device port.

The method may further comprise: receiving, by a battery receiving portion of the adapter, a battery pack; receiving, by the adapter via the battery receiving portion, power from the battery pack; and providing, by the adapter via the second accessory device port, power to the accessory device; and preferably, the battery pack is a power tool battery pack.

The method may further include: (i) receiving, by the first accessory device port, a second accessory device after disconnecting the accessory device; and providing, by the garage door opener, power to the second accessory device via the first accessory device port; or (ii) the accessory device is at least one selected from the group consisting of a wireless speaker, a fan, or a light.

Another aspect provides a method of operating an accessory device system including an adapter and an accessory device, the method comprising: receiving, by an accessory device port on the adapter, the accessory device; receiving, by a battery receiving portion of the adapter, a battery pack; providing, by the adapter via the accessory device port, power to the accessory device received from the battery pack via the battery receiving portion; receiving, by the adapter via the accessory device port, identity and status data from the accessory device; sending, by an electronic controller of the adapter having a wireless transceiver, the identity and status data regarding the accessory device to the peripheral device; receiving, by the electronic controller, settings data regarding the accessory device from the peripheral device; and providing, via the adapter, the settings data to the accessory device to control the accessory device.

The method of may further comprise: supporting, by the battery pack, the adapter and the accessory device, with a bottom of the battery pack engaging a supporting surface and the adapter and the accessory device positioned above the battery pack.

In the method: (i) the battery pack may be a power tool battery pack; or (ii) the accessory device is a wireless speaker, a fan, or a light, and the identity data indicates that the accessory device is a wireless speaker, a fan, or a light.

The peripheral device and the adapter may communicate via a network and server; and preferably, the adapter may communicate wirelessly with the network via the wireless transceiver.

The method may further include: disconnecting, by the accessory device port, from the accessory device; receiving, by the accessory device port, a second accessory device; providing, by the adapter, power to the second accessory device via the accessory device port; receiving, by the adapter via the accessory device port, second identity and status data from the second accessory device; sending, by an electronic controller of the adapter having a wireless transceiver, the second identity and status data regarding the second accessory device to the peripheral device; receiving, by the electronic controller, second settings data regarding the second accessory device from the peripheral device; and providing, via the adapter, the second settings data to the second accessory device to control the second accessory device.

Other features and aspects of the invention will become apparent by consideration of the following detailed description and accompanying drawings.

### BRIEF DESCRIPTION OF THE DRAWINGS

FIG. 1 is a view of a garage door opener system.
FIG. 2 is a view of a garage door opener of the garage door system in FIG. 1.
FIG. 3 is a block power diagram of the garage door opener of FIG. 2.
FIG. 4 is a block communication diagram of the garage door opener of FIG. 2.
FIG. 5 is a side view of a housing of the garage door opener system of FIG. 1.
FIG. 6 is a front perspective view of an accessory device for use with the garage door opener system of FIG. 1.
FIG. 7 is a rear perspective view of the accessory device of FIG. 6.
FIG. 8 is a perspective view of an adapter.
FIG. 9 is a lower perspective view of the adapter of FIG. 8.
FIG. 10 is a rear view of the adapter of FIG. 8.
FIG. 11 is a front view of the adapter of FIG. 8.
FIG. 12 is a first side view of the adapter of FIG. 8.
FIG. 13 is a second side view of the adapter of FIG. 8.
FIG. 14 is a top view of the adapter of FIG. 8.
FIG. 15 is a bottom view of the adapter of FIG. 8.
FIG. 16 is a block diagram of the adapter of FIG. 8.
FIG. 17 is a view of a battery pack that may be coupled to the adapter of FIG. 8 in some embodiments.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways. Also, it is to be understood that the phraseology and terminology used herein is for the purpose of description and should not be regarded as limiting.

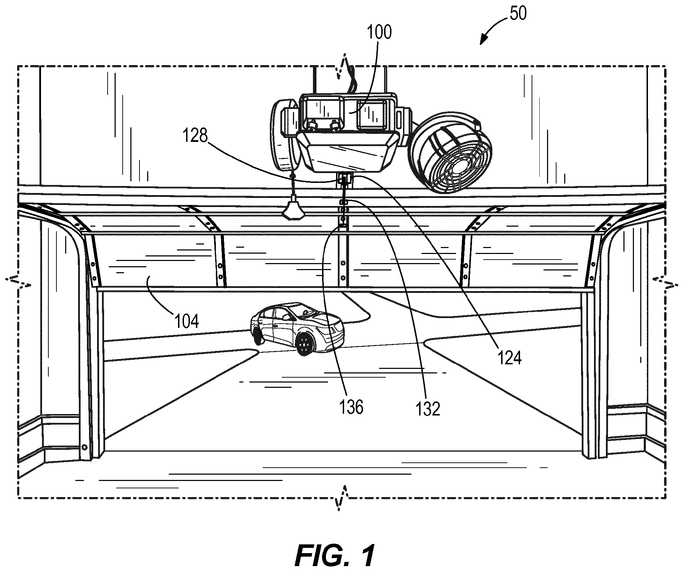

FIGS. 1-2 illustrate a garage door system 50 including a garage door opener 100 operatively coupled to a garage door 104. The garage door opener 100 includes a housing 108 supporting a motor that is operatively coupled to a drive mechanism 116. The drive mechanism 116 includes a transmission coupling the motor to a drive chain 120 having a shuttle 124 configured to be displaced along a rail assembly 128 upon actuation of the motor. The shuttle 124 may be selectively coupled to a trolley 132 that is slidable along the rail assembly 128 and coupled to the garage door 104 via an arm member.

The trolley 132 is releaseably coupled to the shuttle 124 such that the garage door system 50 is operable in a powered mode and a manual mode. In the powered mode, the trolley 132 is coupled to the shuttle 124 and the motor is selectively driven in response to actuation by a user (e.g., via a key pad or wireless remote in communication with the garage door opener 100). As the motor is driven, the drive chain 120 is driven by the motor along the rail assembly 128 to displace the shuttle 124 (and, therefore, the trolley 132), thereby opening or closing the garage door 104. In the manual mode, the trolley 132 is decoupled from the shuttle 124 such that a user may manually operate the garage door 104 to open or close without resistance from the motor. The trolley 132 may be decoupled, for example, when a user applies a force to a release cord 136 to disengage the trolley 132 from the shuttle 124. In some embodiments, other drive systems are included such that, for example, the drive mechanism 116 includes a transmission coupling the motor to a drive belt that is operatively coupled to the garage door 104 via a rail and carriage assembly.

The housing 108 is coupled to the rail assembly 128 and a surface above the garage door (e.g., a garage ceiling or support beam) by, for example, a support bracket 148. The garage door opener further includes a light unit 152 including a light (e.g., one or more light emitting diodes (LEDs)) enclosed by a transparent cover or lens 156), which provides light to the garage. The light unit 152 may either be selectively actuated by a user or automatically powered upon actuation of the garage door opener 100. In one example, the light unit 152 may be configured to remain powered for a predetermined amount of time after actuation of the garage door opener 100.

The garage door opener 100 further includes an antenna 158 enabling the garage door opener 100 to communicate wirelessly with other devices, such as a smart phone or network device (e.g., a router, hub, or modem), as described in further detail below. The garage door opener 100 is also configured to receive, control, and/or monitor a variety of accessory devices or modules, such as a backup battery unit 190, a speaker 192, a fan 194, an extension cord reel 196, among others.

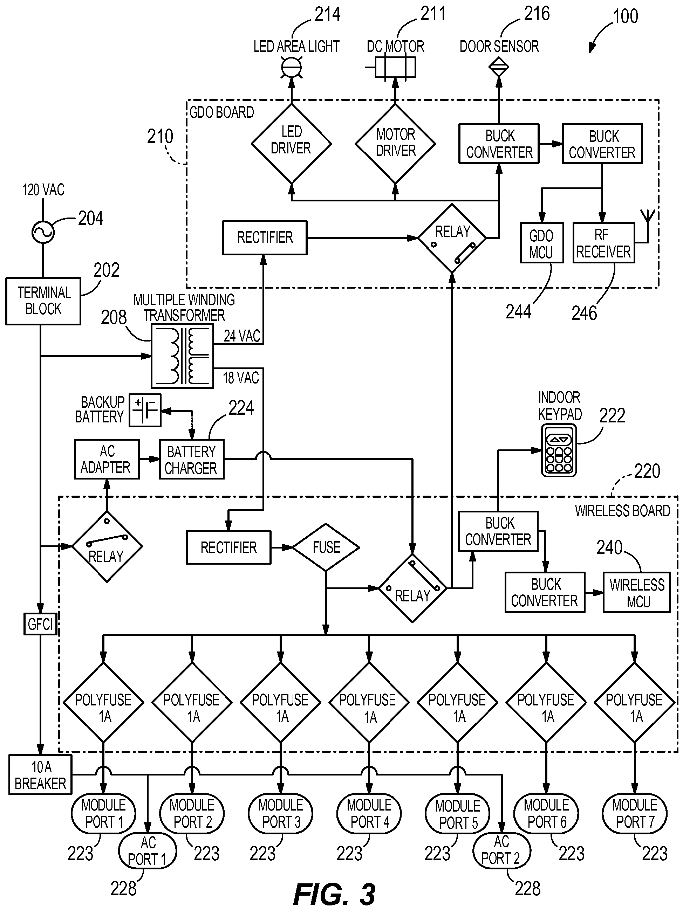

FIG. 3 illustrates a block power diagram of the garage door opener 100. The garage door opener 100 includes a terminal block 202 configured to receive power from an external power source 204, such as a standard 120 VAC power outlet. The terminal block 202 directs power, via a transformer 208, to a garage door opener (GDO) board 210 for supply to components thereof as well as a motor 212 (used to drive the drive mechanism 116, as described above), LEDs 214 (of the light unit 152), and garage door sensors 216. The terminal block 202 further directs power via the transformer 208 to a wireless board 220 and components thereof, as well as a wired keypad 222 and module ports 223. The terminal block 202 also directs power to a battery charger 224 and AC ports 228. The module ports 223 are configured to receive various accessory devices, such as a speaker, a fan, an extension cord reel, a parking assist laser, an environmental sensor, a flashlight, and a security camera. One or more of the accessory devices are selectively attachable to and removable from the garage door opener 100, and may be monitored and controlled by the garage door opener 100.

The wireless board 220 includes a wireless microcontroller 240, among other components. The GDO board 210 includes, among other components, a garage door opener (GDO) microcontroller 244 and a radio frequency (RF) transceiver 246.

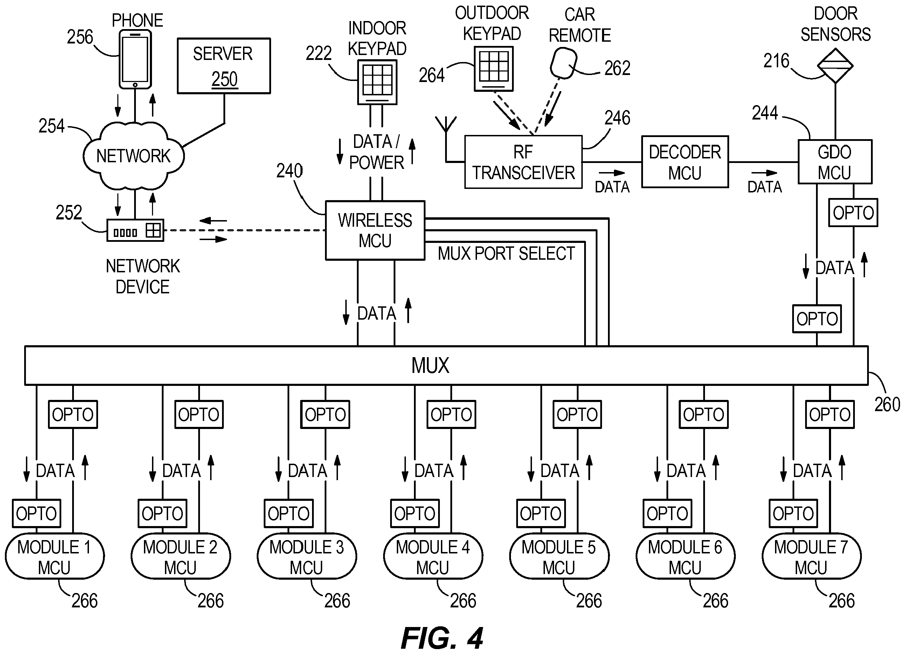

FIG. 4 illustrates a block communication diagram of the garage door opener 100. The wireless microcontroller 240 is coupled to the antenna 158 and enables wireless communication with a server 250 via a network device 252 and network 254, as well as with a smart phone 256 (and other similar external devices, such as tablets and laptops). The network device 252 may be, for example, one or more of a router, hub, or modem. The network 254 may be, for example, the Internet, a local area network (LAN), another wide area network (WAN) or a combination thereof. The wireless microcontroller 240 may include, for example, a Wi-Fi radio including hardware, software, or a combination thereof enabling wireless communications according to the Wi-Fi protocol. In other embodiments, the wireless microcontroller 240 is configured to communicate with the server 250 via the network device 252 and network 254 using other wireless communication protocols. The network 254 may include various wired and wireless connections to communicatively couple the garage door opener 100 to the server 250. As illustrated, the wireless microcontroller 240 also includes wired communication capabilities for communicating with the GDO microcontroller 244 via the multiplexor 260. In some embodiments, the wireless microcontroller 240 and the GDO microcontroller 244 are directly coupled for communication. In some embodiments, the wireless microcontroller 240 and the GDO microcontroller 244 are combined into a single controller.

The RF transceiver 246 is wirelessly coupled to various user actuation devices, including one or more wireless remotes 262 and wireless keypads 264, to receive and provide to the GDO microcontroller 244 user actuation commands (e.g., to open and close the garage door 104). The smart phone 256 may also receive user input and, in response, provide (directly or via the network 254) to the wireless microcontroller 240 user actuation commands for the garage door opener 100 or commands to control one or more of the accessory devices. The multiplexor 260 enables communication between and among the wireless microcontroller 240, the GDO microcontroller 244, and the accessory microcontrollers 266 (of the accessory devices previously noted).

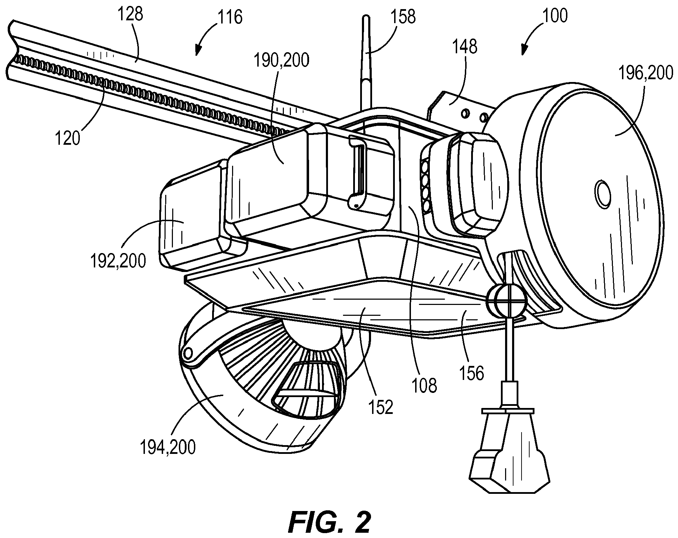

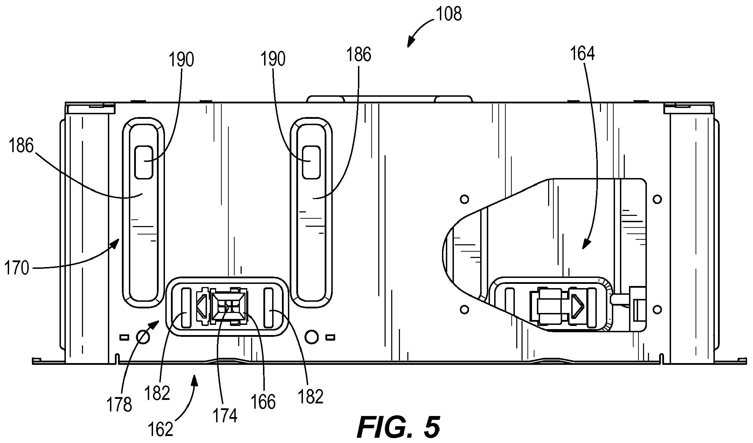

With reference to FIG. 5, the housing 108 includes accessory ports 162 that receive and support accessory devices, as noted above, which are modular, interchangeable accessory devices and are generically referred to as the accessory devices 200 (see, e.g., FIG. 2) In the illustrated embodiment, the housing 108 has eight accessory ports 162 with two ports 162 disposed on each side of the housing 108. However, this configuration is merely exemplary - that is, the housing 108 may include more than eight ports 162 or less than eight ports 162, and each side of the housing 108 may include more or less than two ports 162. Additionally, the housing 108 may include more or less than four sides with each having one or more ports 162, and other surfaces of the housing (e.g., the top and bottom) may include one or more ports 162.

With continued reference to FIG. 5, each port 162 includes a communication interface 166 and a coupling interface 170. The communication interface 166 includes an electrical connector 174 disposed within a recess 178. The electrical connector 174 is configured to facilitate electrical communication and data communication between the accessory device 200 and the garage door opener 100. The electrical connector 174 may be any type of powered input/output port. Additionally, in further embodiments the electrical connector 174 may define separate power connectors and data connectors, which may similarly be any type of power connectors and data connectors. In the illustrated embodiment, two slots 182 are formed on either side of the electrical connector 174 and receive a portion of an accessory device 200 to align and mechanically couple the accessory device 200 with housing 108. The coupling interface 170 is defined by a pair of spaced apart, raised surfaces 186 defined on either side of the communication interface 166. Each raised surface 186 includes a chamfered edge and has an aperture 190 defined there through. However, the raised surfaces 186 may be omitted in other embodiments. The apertures 190 are configured to receive portions of the accessory devices 200 to facilitate mechanical coupling of the accessory device 200 to the garage door opener 100.

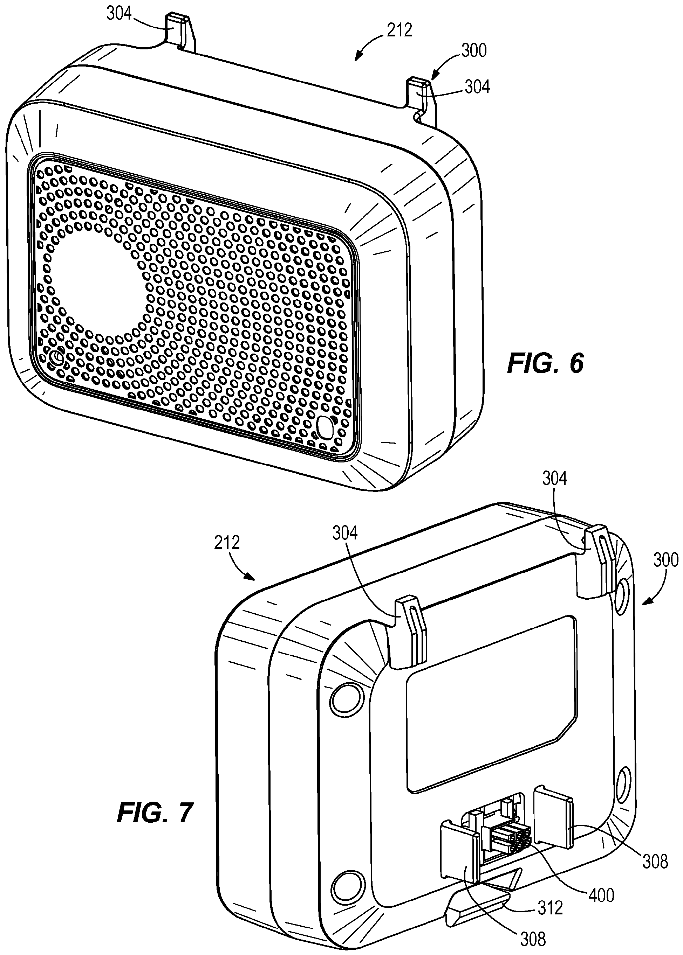

FIGS. 6 and 7 illustrate an example of one of the accessory devices 200 - an accessory speaker 212 - that is configured to be detachably coupled to the garage door opener 100. In the illustrated embodiment, the speaker 212 is a wireless speaker 212 (e.g., a Bluetooth® speaker) that may be wirelessly coupled to a peripheral device, such as the smart phone 256 or a tablet. In one embodiment, the speaker 212 receives an audio stream from the peripheral device communicating with the garage door opener 100, and subsequently drives a speaker 212 to output the audio stream using power from the garage door opener 100 via an electrical mounting interface 400. In another embodiment, the wireless speaker 212 receives an audio stream wirelessly directly from the peripheral device via an integral transceiver, and drives a speaker 212 to output the audio stream using power from the garage door opener 100 via the electrical mounting interface 400.

With reference to FIG. 7, the speaker 212 includes a mechanical mounting interface 300 configured to be coupled to the coupling interface 170 of the housing 108, and the electrical mounting interface 400 configured to be coupled to the communication interface 166 of the housing 108. The mechanical mounting interface 300 includes a pair of hooks 304 that are received within the apertures 190 of the coupling interface 170, a pair of projections 308 disposed on opposing sides of the electrical mounting interface 400, and at least one protruding latch member 312 configured to engage a corresponding retention member on the housing 108. The projections 308 are configured to be received within the slots 182 to assist with alignment of the electrical mounting interface 400 and the communication interface 166. When coupled, the speaker 212 receives power from the garage door opener 100 via a connection defined by the electrical mounting interface 400 and the communication interface 166. The speaker 212 also sends data to and receives data from the garage door opener 100 via a connection defined by the electrical mounting interface 400 and the communication interface 166.

The speaker 212 further includes a controller (e.g., microcontroller 266) in communication with the wireless microcontroller 240 of the garage door opener 100. The controller includes a memory storing an initial data set including a unique identifier, a predetermined initial status field, and a predetermined initial settings field that is communicated to the garage door opener 100 each time the speaker 212 is coupled to the port 162. Thereafter, the controller is configured to send and receive data from, for example, the server 250 via the wireless microcontroller 240. More specifically, the controller receives updates to the settings field of the data set based on data received from the wireless microcontroller 240. The controller also updates the status field of the data set, which is sent to the wireless microcontroller 240 for communication to the peripheral device via the server 250.

In one embodiment, the status field includes, for example, on/off state of the speaker, the pairing status (e.g., Bluetooth® pairing status), and speaker volume, among others. The settings field includes an on/off toggle, a pairing toggle (e.g., to turn pairing on/off), and a volume value, among others. In this example, the user may set the values for the settings field (e.g., via the smart phone 256 or other peripheral device), which updates the speaker 212 to turn on/off, turn pairing on/off, or alter the volume of the speaker. For example, the smart phone 256 may communicate updated settings for the settings field on the server 250. In turn, for example, the server 250 sends the updated settings to the speaker 212 via the network 254, network device 252, and wireless microcontroller 240.

Each of the accessory devices 200 may be interchangeably coupled to the ports 162 of the housing 108 due to the common mechanical mounting interfaces 300 and electrical mounting interfaces 400. In other words, each accessory device 200 may be coupled to any port 162 on the housing 108. This modular design allows a user to couple desired accessory devices 200 to the garage door opener 100 in a preferred location, while removing accessory devices 200 that the user does not require. This modular design allows the user to customize the garage door opener 100 to fit their specific needs.

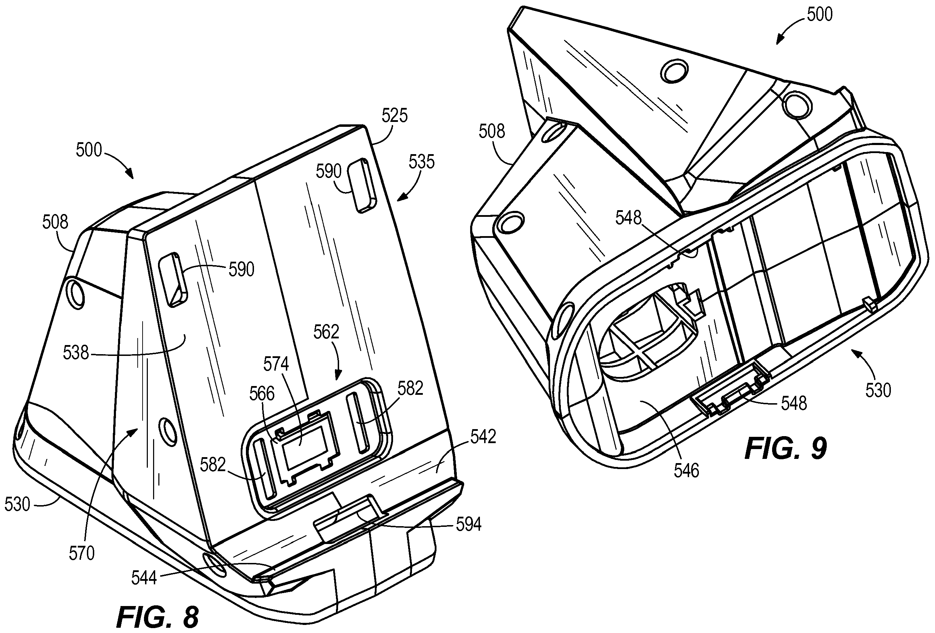

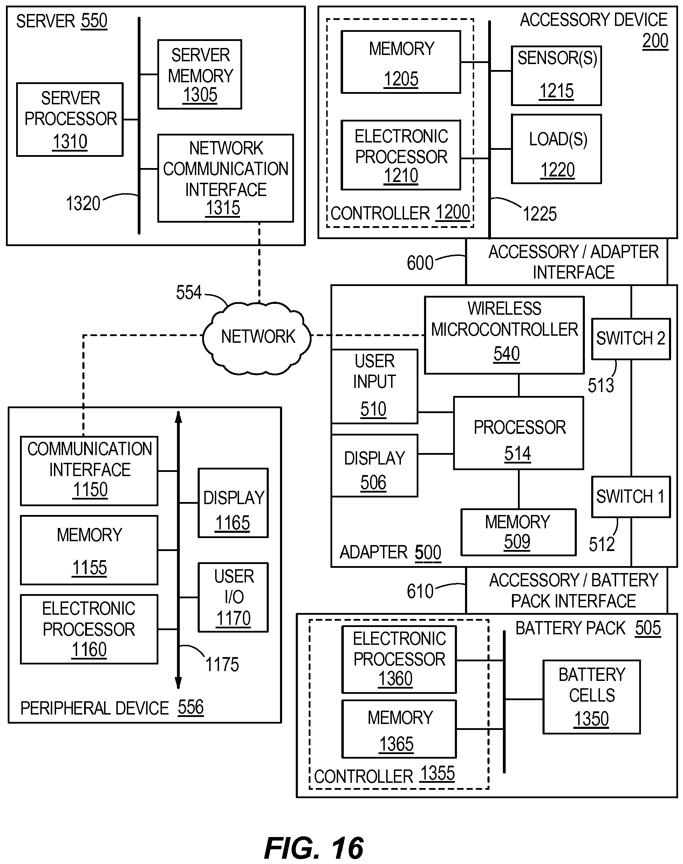

FIGS. 8-16 illustrate an adapter 500 that includes a housing 508 defined by a main body 525, a battery receiving portion 530, and an accessory receiving portion 535. As will be described in greater detail below, the adapter 500 is configured to selectively receive a battery pack 505 (see FIGS. 16-17), such as a power tool battery pack, and one or more of the accessory devices 200. The adapter 500 couples the battery pack 505 to the accessory device 200 such that the battery pack 505 can power the accessory device 200.

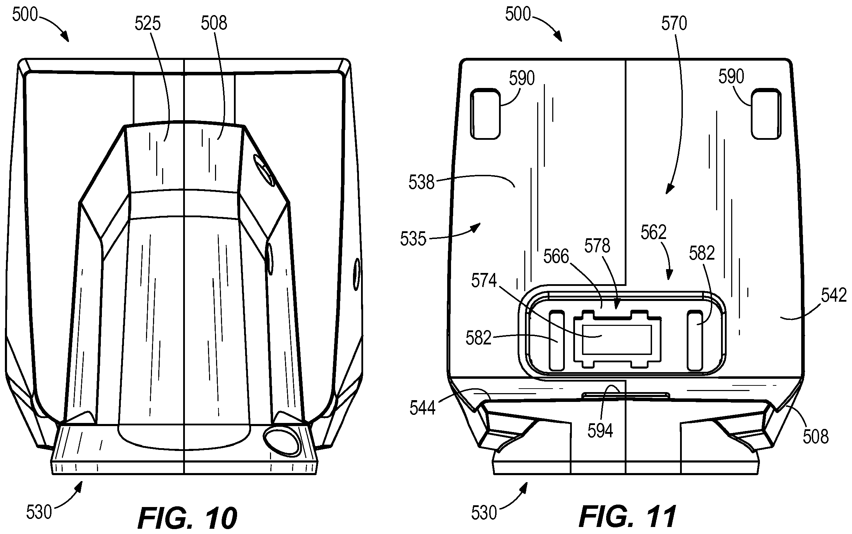

With reference to FIGS. 8 and 11, the accessory receiving portion 535 is defined by a planar support surface 538 and a lower groove 542 that at least partially supports the accessory device 200. The accessory receiving portion 535 includes at least one accessory port 562 that receives and supports modular, interchangeable accessory devices 200. The accessory port 562 is similar to the ports 162 disposed on the housing 108 of the garage door opener 100 and may be configured to receive each of the accessory devices 200 described above. In the illustrated embodiment, the main body 525 includes a single accessory port 562. However, this configuration is merely exemplary - that is, the housing 508 may include more than one port 562 such that the adapter 500 may be coupled to a plurality of accessory devices 200.

With continued reference to FIGS. 8 and 11, the accessory port 562 includes a communication interface 566 and a coupling interface 570. The communication interface 566 includes an electrical connector 574 disposed within a recess 578 on the planar support surface 538. The electrical connector 574 is configured to facilitate electrical communication and data communication between the accessory device 200 and the adapter (e.g., to couple the accessory device 200 to the battery pack). The electrical connector 574 may be any type of powered input/output port. Additionally, in further embodiments the electrical connector 574 may define separate power connectors and data connectors, which may similarly be any type of power connectors and data connectors. In the illustrated embodiment, two slots 582 are formed on either side of the electrical connector 574 and receive a portion of an accessory device 200 to align and mechanically couple the accessory device 200 with housing 508.

The coupling interface 570 is defined by a pair of spaced apart apertures 590 disposed on an upper end of the support surface and a catch 594 defined in the groove. Each of the apertures 590 is configured to receive portions of the accessory devices 200 to facilitate mechanical coupling of the accessory device 200 to the adapter 500. The catch 594 is configured to receive, for example, the latch member 312 of the accessory device 200 to secure and maintain engagement of the accessory device 200 to the adapter 500. In addition, the groove 542 defines lower surfaces for supporting the accessory device 200.

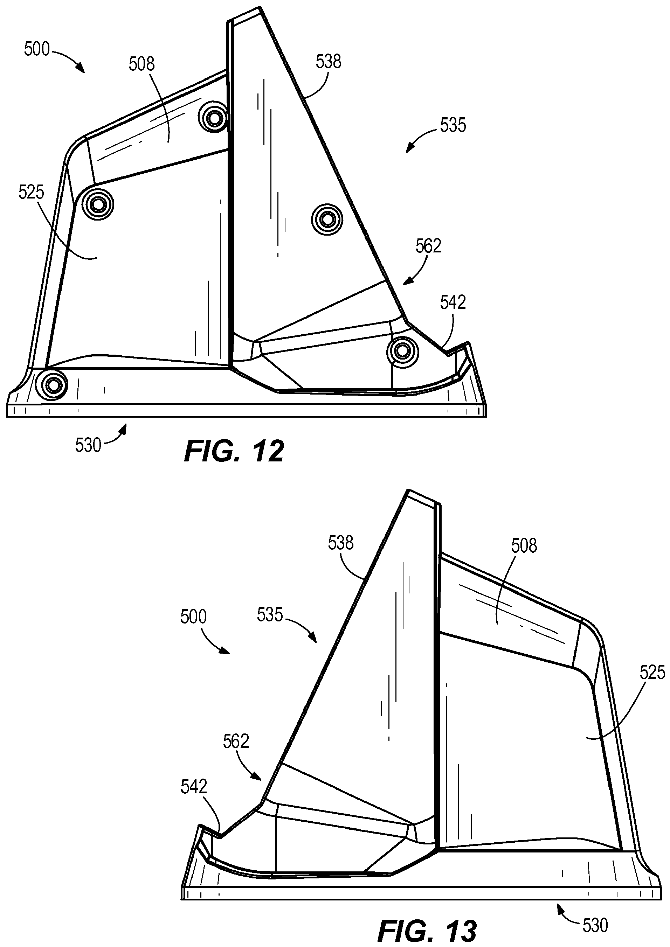

With reference to FIGS. 12 and 13, the planar support surface 538 defines an axis angled relative to a vertical axis and horizontal axis such that the accessory device rests on the support surface when attached to the adapter 500. The groove 542 has at least one surface 544 that defines an axis angled relative to the axis of the planar support surface 538 and the vertical axis.

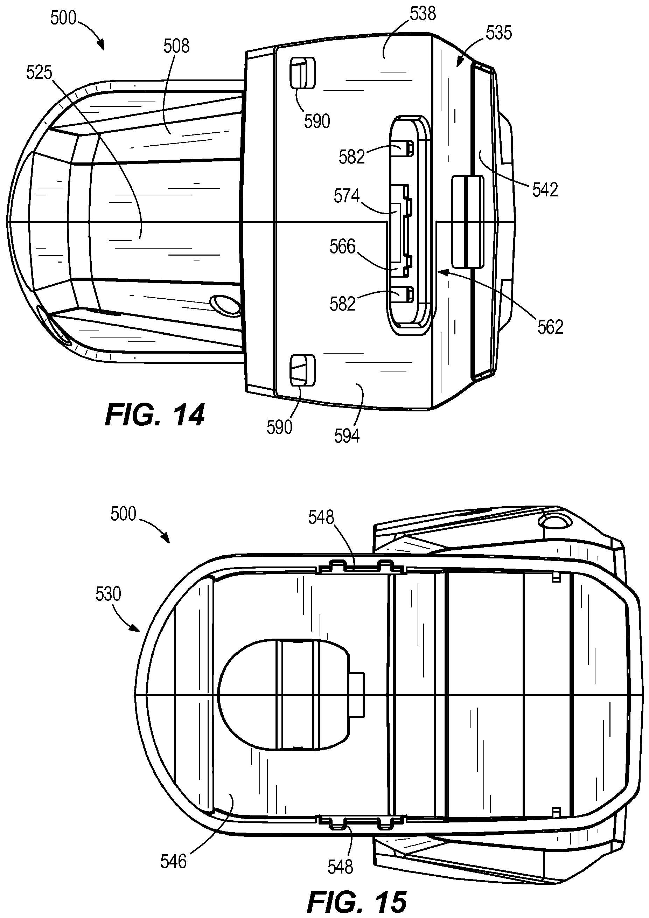

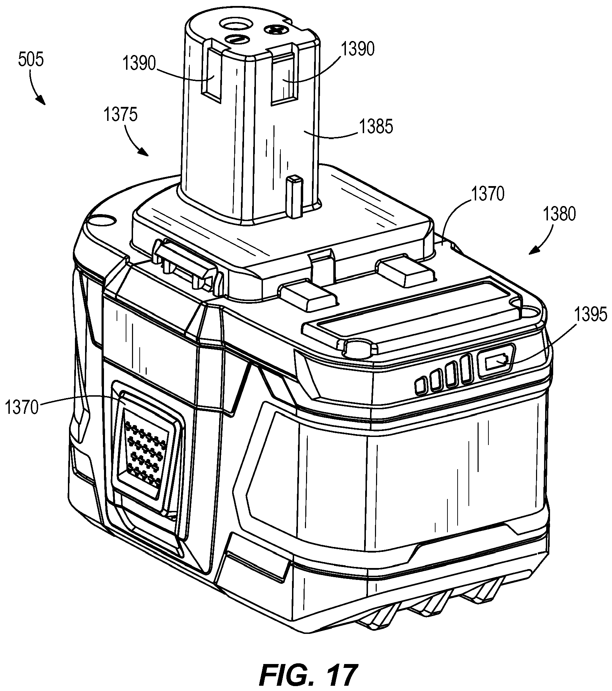

With reference to FIGS. 9 and 15, the battery receiving portion 530 is defined by a recess 546 that is sized and shaped to receive the battery pack 505. The battery receiving portion 530 includes adapter electrical contacts that are configured to mechanically and electrically engage battery contacts (e.g., contacts 1390 of FIG. 17) to communicate electrical power and/or data signals therebetween. In addition, the battery receiving portion 530 includes two slots 548 disposed on opposed sides of the recess 546 that are configured to receive battery pack latch members 1370 (see FIG. 17) to secure and maintain engagement of the battery pack 505 to the adapter 500. In the illustrated embodiment, the battery receiving portion 530 is configured to receive a battery pack 505 that is inserted along a vertical insertion axis. However, in other embodiments, the battery receiving portion 530 may be configured to receive the battery pack 505 configured as a 'slide on' battery pack that is inserted along a horizontal insertion axis.

FIG. 16 is a block diagram illustrating the adapter 500 and connected components, including a battery pack 505, the accessory device 200, the network 554, a server 550, and a peripheral device 556. The adapter 500 includes a display 506, a memory 509, and user input 510. The user input 510 has at least one actuator (e.g., button, switch, lever, touchscreen, etc.) that is configured to control operation of the adapter 500. In the illustrated embodiment, the user input 510 includes two actuators that are each configured to operate a switch, a first switch 512 and a second switch 513, respectively. For example, the first switch 512 is disposed between the battery pack 505 and an electronic processor 514 of the adapter as well as the accessory device 200 such that the first switch 512 controls the on/off state of the adapter 500 (i.e., whether power is supplied from the battery pack 505 to the adapter 500). When the first switch 512 is closed, the battery pack 505 supplies power to the processor 514 to turn the adapter 500 to an on or active state. The second switch 513 is disposed between the battery pack 505 and the accessory device 200 such that the second switch 513 controls the on/off state of the accessory device 200 (i.e., whether power supplied to the adapter 500 from the battery pack 505 is passed to the accessory device 200). When the second switch 513 is closed, the battery pack 505 supplies power (received via the first switch 512 when the first switch 512 is closed) to the accessory device 200. In other words, the adapter 500 provides power to the accessory device 200 when both the first switch 512 and the second switch 513 are closed.

In one embodiment, the first switch 512 is closed when the battery pack 505 is fully and properly attached to the adapter 500. That is, the first switch 512 is operated to close by a mechanism in the coupling of the battery pack 505 to the receiving portion 530. For example, the engagement of a latch (see latch 1370, FIG. 17) of the battery pack 505 may close the first switch 512. In other embodiments, the first switch 512 is configured to be selectively actuated by the user (e.g., by a button, switch, lever, touchscreen, etc. disposed on the housing 508). In either case, the actuator may physically open or close the first switch 512 upon actuation (i.e., make or break a conductive connection), or the actuator may communicate a control signal to the processor 514 of the adapter 500 upon actuation, which causes the processor 514 to control the first switch 512 to open or close.

The second switch 513 is configured to be selectively actuated by the user (e.g., by a button, switch, lever, touchscreen, etc. disposed on the housing 508). The actuator for the second switch 513 may physically open or close the second switch 513 upon actuation, or the actuator may communicate a control signal to the processor 514 of the adapter 500 upon actuation, which causes the processor 514 to control the second switch 513 to open or close.

In the illustrated embodiment, the adapter 500 further includes a wireless microcontroller 540 that is similar to the wireless microcontroller 240, described above with respect to the garage door opener 100, to enable wireless communication. For example, the adapter 500 is configured to wirelessly communicate via the network 554 with a server 550 and a peripheral device 556 (e.g., a smart phone, tablet, laptop, or the like). The network 554 may be, for example, the Internet, a local area network (LAN), another wide area network (WAN) or a combination thereof, and may include one or more network devices similar to the network device 252. The network 554 may also include various wired and wireless connections to communicatively couple the adapter 500 to the server 550 and peripheral device 556. The wireless microcontroller 540 may include, for example, a Wi-Fi radio including hardware, software, or a combination thereof enabling wireless communications according to the Wi-Fi protocol. In other embodiments, the wireless microcontroller 540 is configured to communicate with the server 550 via the network 554 using other wireless communication protocols. Regardless of the protocol, the wireless microcontroller 540 includes a wireless transceiver to enable wireless communications. The wireless microcontroller 540 and processor 514 may be collectively referred to as an electronic controller or processor of the adapter 500. The electronic controller may execute software, which may be stored in the memory 509 or a memory of the wireless microcontroller 540, to carry out the functionality of the adapter 500 described herein.

Although separately labeled and described, the server 550 may be the same server (in whole or part) as the server 250, the network 554 may be the same network (in whole or part) as the network 254, and the peripheral device 556 may be the same peripheral device (in whole or part) as the smart phone 256.

Similar to the communications described above between the peripheral device (e.g., the smart phone 256) and the accessory device 200 when the accessory device 200 is coupled with the garage door opener 100, communication may occur between the accessory device 200 and the peripheral device 556 via the adapter 500. Such communications may include the communication of a data set including at least identifier (ID) data, settings data, and status data, from each of the different accessory devices 200 coupled to the adapter 500 to the peripheral device 556 via the wireless microcontroller 540. In one communication method, the adapter 500 acts as an intermediary communication device or pass through device - that is, the wireless microcontroller 540 determines the accessory 200 is received in the port and understands data sets that it sends and receives is divided into categories (e.g., unique identifier, status, settings), but does not actually process or 'understand' the data contained within the data set. Rather, it simply routes the data set associated with each connected port to the peripheral device 556 via the server 550. This, for example, allows the adapter 500 to receive one of multiple different accessories in a single port, and allows each accessory device 200 to be moved from a first port to another port (when the adapter 500 includes multiple ports).

For example, the server 550 may maintain data sets for each accessory device. The adapter 500 receives data from the accessory device 200 and communicates the data to the server 550 to update the data set. In turn, the server 550 communicates (e.g., based on a push or pull operation) the updated data set to the peripheral device 556 via the network 554. Likewise, the peripheral device 556 may generate (e.g., based on user input) data that is transmitted, via the network 554, to the server 550 to update the data set associated with the accessory device 200. The server 550, in turn, communicates (e.g., based on a push or pull operation) the updated data set to the accessory device 200 via the network 554 and the wireless microcontroller 540. In some embodiments, the adapter 500 directly communicates information between the accessory device 200 and the peripheral device 556 via the network 554, rather than via the server 550.

The communications between the peripheral device 556 and the accessory device 200 enable the peripheral device 556 to determine the identity of the accessory device 200 (based on obtained ID data), to determine the status and settings of the accessory device 200 (based on received status data and settings data), and to control the accessory device 200 (e.g., to turn on/off the device and to vary settings and thresholds of the device based on sending settings data).

In other embodiments, however, the adapter 500 is not configured to communicate with the peripheral device 556. For example, the wireless microcontroller 540 may not be included in some embodiments. In such embodiments, either the accessory device 200 or the adapter 500 includes user input devices to control the operating state of the accessory device 200. The adapter 500 may further obtain status information from the accessory device 200 coupled thereto and provide the status information to a user via the display 506.

FIG. 16 also illustrates one exemplary block diagram of one of the accessory devices 200 in further detail. The accessory device 200 may be a speaker (e.g., the speaker 212), a fan, an extension cord reel, an environmental sensor, a flashlight, or a security camera, among others. As illustrated, the accessory device 200 includes a controller 1200 (e.g., the microcontroller 266 of FIG. 2) having a memory 1205 and an electronic processor 1210, one or more sensors 1215 (e.g., temperature sensors, humidity sensors, and carbon monoxide sensors, etc.) and one or more loads 1220 (e.g., indicators, speakers, cameras, lights, motors, etc.) coupled by a bus 1225. The controller 1200 is coupled to the adapter 500 via the electrical mounting interface 400 to enable data communications between the controller 1200 and the adapter 500 and to provide power to the accessory 200. The electronic processor 1210 executes software, which may be stored in memory 1205, to carry out the functions of the accessory device 200 described herein (e.g., to receive and store data from the sensor(s) 1215, to control the load(s) 1220, to communicate data to and receive data from the adapter 500). The particular sensors 1215, loads 1220, and functionality of the controller 1200 varies depends on the type of accessory 200. The accessory device 200 may receive settings data from the peripheral device 556 via the adapter 500, as described above. In response, the controller 1200 may store the settings data (e.g., in the memory 1205) and control the load(s) 1120, sensor(s) 1215, or both, in accordance with the settings data. For example, when the accessory device 200 is a fan, in response to received settings data from the peripheral device 556, the electronic processor 1210 may control a fan motor (an example of the load 1220) to turn on, off, or adjust speed based on the received settings data.

The accessory device 200 is configured to interface with the adapter 500 in the same way that the accessory device 200 interfaces with the garage door opener 100. The mechanical mounting interface 300 of the accessory device 200 (see FIGS. 6-7) is configured to be coupled to the coupling interface 570 of the housing 508, and the electrical mounting interface 400 of the accessory device 200 (see FIGS. 6-7) is configured to be coupled to the communication interface 566 of the housing 508. In particular, the hooks 304 of the mechanical mounting interface 300 are received within the apertures 590 of the coupling interface 570, the pair of projections 308 are received within the slots 582, the latch member 312 engages the catch 594, and the electrical mounting interface 400 electromechanically engages the communication interface 566. The projections 308 and the slots 582 assist with alignment of the electrical mounting interface 400 and the communication interface 566. When coupled, the accessory device 200 receives power from the adapter 500 via a connection defined by the electrical mounting interface 400 and the communication interface 166. The accessory device 200 also sends data to and receives data from the adapter 500 via a connection defined by the electrical mounting interface 400 and the communication interface 566. The accessory/adapter interface 600 illustrated in FIG. 16 includes the mechanical mounting interface 300, the electrical mounting interface 400, the coupling interface 570, and the communication interface 566.

FIG. 16 also illustrates one exemplary block diagram of the peripheral device 556 in further detail. As illustrated, the peripheral device 556 includes a communications interface 1150, a memory 1155, an electronic processor 1160, a display 1165, and user input/output 1170 coupled by bus 1175. The communication interface 1150 is coupled (wired and/or wirelessly) to the network 554 and enables the electronic processor 1160 (and, thereby, the peripheral device 556) to communicate with the server 550 (and, thereby, the adapter 500 and the accessory device 200). The electronic processor 1160 executes software, which may be stored in the memory 1155, to carry out the functionality of the peripheral device 556 described herein (e.g., send data to and from the adapter 500 to control and monitor operation of the accessory device 200). The user input/output 1170 include one or more push buttons, toggle switches, speakers, and vibration generators for receiving user input and providing user output. In some embodiments, the display 1165 is a touch screen display and is part of the user input/output 1170. The display provides visual output regarding the adapter 500 and the accessory device 200.

FIG. 16 also illustrates an exemplary block diagram of the server 550. As illustrated, the server 550 includes a network communication interface 1315, a server memory 1305, and a server processor 1310 coupled by bus 1320. The network communication interface 1315 is coupled (wired and/or wirelessly) to the network 554 and enables the server processor 1310 (and, thereby, the server 550) to communicate with the adapter 500 (and, thereby, the accessory device 200) and the peripheral device 556. The server memory 1305 stores the accessory information (e.g., the data set including the ID data, settings data, and status data for each of the accessory devices 200), as well as operational data and software. The server processor 1310 executes software, which may be stored in the memory 1305, to carry out the functionality of the server 550 described herein. For example, the server processor 1310 reads and writes the accessory information to the memory 1305. Although illustrated as a single server, the server 550 may be implemented by one or more servers co-located or located separately from one another and, for instance, coupled by various communication networks.

The battery pack 505 is coupled to the adapter 500 via the adapter/battery interface 610. The adapter/battery interface 610 includes the electrical and mechanical connections of the battery pack 505 and the adapter 500, including the battery terminals (e.g., contacts 1390 of FIG. 17) and adapter terminals for transmitting power and, in some instances, data; the battery receiving portion 530 of the adapter 500 described with respect to FIGS. 9 and 15 used to secure the battery pack 505 to the adapter 500; and the portion of the battery pack 505 received in the battery receiving portion 530 (see insertion portion 1375 of FIG. 17).

The battery pack 505 includes battery cells 1350 and a battery controller 1355 having an electronic processor 1360 and a memory 1365. The electronic processor 1360 executes instructions stored in the memory 1365 to control the functionality of the battery pack 505 described herein, such as to control the charge and discharge of the battery cells 1350 (e.g., via switching elements (not shown)). The battery cells 1350 may provide a voltage output of about 18 volts, of another value in a range between 17 to 21 volts, or another value, such as about 12 volts, about 28 volts, about 36 volts, about 48 volts, another value or range between 12 to 48 volts, or another value. The term "about" may indicate a range of plus or minus 20%, 15%, 10%, 5%, or 1% from an associated value. The battery cells 1350 may have various chemistry types, such as lithium ion, a nickel cadmium, etc.

FIG. 17 illustrates an example of the battery pack 505 that may be coupled to the adapter 500 via the adapter/battery pack interface 610. The battery pack 505 includes latches 1370 on either side of the pack for engaging the slots 548 of the battery receiving portion 530 on the adapter 500. The battery pack 505 further includes an insertion portion 1375 that is received by the battery receiving portion 530 of the adapter 500. The insertion portion 1375 includes a top support portion 1380 having a stem 1385 extending vertically from the top support portion 1380. The stem 1385 has contacts 1390 that supply power to the adapter 500 and may communicate data between the adapter 500 and the battery pack 505. When coupled to the adapter 500, the battery pack 505 may provide support to the adapter 500. In other words, the adapter 500 may rest on top of the battery pack 505. For example, the battery pack 505 may engage a support surface (e.g., a table top or floor), and the adapter 500 and coupled accessory device may be positioned above the battery pack 505. The battery pack 505 further includes a fuel gauge 1395 that indicates a state of charge of the battery pack. The battery pack 505 may be a power tool battery pack configured to power a power tools (e.g., drills/drivers, impact drills/drivers, hammer drills/drivers, saws, and routers) having a battery receiving portion similar to the battery receiving portion 530.

As noted above, although the adapter 500 is illustrated as having one port 562, in some embodiments, the adapter 500 includes more than one port 562 for coupling to a plurality of the accessory devices 200. In such embodiments, the adapter 500 is operable to serves as a communication interface to the network 554 such that each of the accessory devices 200, when coupled to the adapter 500, may communicate with the server 550 and peripheral device 556 for monitoring and control as described above.

Thus, embodiments described herein provide, among other things, a method of operating an accessory device system including a garage door opener, an adapter, and one or more accessory devices whereby a first accessory device of the one or more accessory devices may be coupled to the garage door opener, operated based on power from the garage door opener, removed from the garage door opener, coupled to the adapter, and then operated based on power from the adapter received via a battery pack selectively coupled to a battery receiving portion of the adapter.

In another embodiment, an accessory device system includes a garage door opener, an adapter, and one or more accessory devices whereby the garage door opener has a first accessory device port configured to couple to the one or more accessory devices and the adapter has a second accessory device port configured to couple to the one or more accessory devices. The garage door opener is further configured to provide power to a first accessory device of the one or more accessory devices via the first accessory device port. The adapter further includes a battery receiving portion configured to be selectively coupled to a battery pack and to receive power from the battery pack, and the adapter is further configured to provide power, received from the battery pack, to the first accessory device via the second accessory device port.

In another embodiment, an accessory device system includes an adapter, a battery pack selectively coupled to a battery receiving portion of the adapter, and a first accessory device coupled to an accessory device port of the adapter. The adapter further includes an electronic controller having a wireless transceiver and operable to communicate with a peripheral device to one or more of provide identity and status information regarding the first accessory device and to receive settings data to control the first accessory device. The adapter receives the identity and status information from the first accessory device, and provides the settings data to the first accessory device to control the first accessory device. In some instances, the peripheral device and the adapter communicate via a network and server, and the adapter communicates wirelessly with the network via the wireless transceiver.

In another embodiment, a method of operating an accessory device system is provided where the system includes an adapter, a battery pack selectively coupled to a battery receiving portion of the adapter, and a first accessory device coupled to an accessory device port of the adapter. The method further includes the adapter receiving identity and status information from the first accessory device, and communicating, by an electronic controller of the adapter having a wireless transceiver, with peripheral device to provide the identity and status information regarding the first accessory device to the peripheral device. The method further includes communicating, via the wireless transceiver of the adapter, with the peripheral device to receive settings data to control the first accessory device, and providing the settings data to the first accessory device to control the first accessory device. In some instances, the peripheral device and the adapter communicate via a network and server, and the adapter communicates wirelessly with the network via the wireless transceiver.

Various features of the invention are set forth in the following claims.

## Claims

1. An accessory device system comprising:
an accessory device;
a garage door opener including a first accessory device port configured to selectively couple to the accessory device and provide power to the accessory device via the first accessory device port; and
an adapter including
a second accessory device port configured to selectively couple to the accessory device, and
a battery receiving portion configured to be selectively coupled to a battery pack and to receive power from the battery pack;
wherein the adapter is configured to provide power, received from the battery pack, to the accessory device via the second accessory device port.

2. The accessory device system of claim 1, wherein the accessory device is at least one selected from the group consisting of a wireless speaker, a fan, or a light.

3. The accessory device system of claim 1, wherein the battery pack is a power tool battery pack including:
battery cells,
a second electronic controller having an electronic processor and a memory, and
a fuel gauge.

4. The accessory device system of claim 1, wherein the accessory device is configured to communicate with a peripheral device via the adapter.

5. The accessory device system of claim 4, wherein the adapter includes a wireless transceiver and is configured to:
communicate with the peripheral device to provide identity and status information regarding the accessory device to the peripheral device,
receive settings data from the peripheral device to control the first accessory device,
receive the identity and status information from the first accessory device, and
provide the settings data to the accessory device to control the accessory device.

6. The accessory device system of claim 1, wherein:
(i) the accessory device is configured to communicate with a peripheral device via the garage door opener; or
(ii) the accessory device is a first accessory device, and the system further comprises a second accessory device, the second accessory device configured to selectively couple to the first accessory device port and to the second accessory device port.

7. The accessory device system of claim 1, wherein the second accessory device port includes a communication interface configured to facilitate electrical communication between the accessory device and the adapter, and a coupling interface configured to mechanically couple the accessory device and the adapter.

8. A method of operating an accessory device system including a garage door opener, an adapter, and one or more accessory devices, the method comprising:
receiving, by a first accessory device port on the garage door opener, the accessory device;
providing, by the garage door opener, power to the accessory device via the first accessory device port;
disconnecting, by the first accessory device port, from the accessory device;
receiving, by a second accessory device port on the adapter, the accessory device; and
providing, by the adapter, power to the accessory device via the second accessory device port.

9. The method of claim 8 further comprising:
receiving, by a battery receiving portion of the adapter, a battery pack;
receiving, by the adapter via the battery receiving portion, power from the battery pack; and
providing, by the adapter via the second accessory device port, power to the accessory device; and
preferably, the battery pack is a power tool battery pack.

10. The method of claim 8, further including:
(i) receiving, by the first accessory device port, a second accessory device after disconnecting the accessory device; and providing, by the garage door opener, power to the second accessory device via the first accessory device port; or
(ii) the accessory device is at least one selected from the group consisting of a wireless speaker, a fan, or a light.

11. A method of operating an accessory device system including an adapter and an accessory device, the method comprising:
receiving, by an accessory device port on the adapter, the accessory device;
receiving, by a battery receiving portion of the adapter, a battery pack;
providing, by the adapter via the accessory device port, power to the accessory device received from the battery pack via the battery receiving portion;
receiving, by the adapter via the accessory device port, identity and status data from the accessory device;
sending, by an electronic controller of the adapter having a wireless transceiver, the identity and status data regarding the accessory device to the peripheral device;
receiving, by the electronic controller, settings data regarding the accessory device from the peripheral device; and
providing, via the adapter, the settings data to the accessory device to control the accessory device.

12. The method of claim 11, further comprising:
supporting, by the battery pack, the adapter and the accessory device, with a bottom of the battery pack engaging a supporting surface and the adapter and the accessory device positioned above the battery pack.

13. The method of claim 12, wherein:
(i) the battery pack is a power tool battery pack; or
(ii) the accessory device is a wireless speaker, a fan, or a light, and the identity data indicates that the accessory device is a wireless speaker, a fan, or a light.

14. The method of claim 12, wherein the peripheral device and the adapter communicate via a network and server; and preferably, the adapter communicates wirelessly with the network via the wireless transceiver.

15. The method of claim 11, further including:
disconnecting, by the accessory device port, from the accessory device;
receiving, by the accessory device port, a second accessory device;
providing, by the adapter, power to the second accessory device via the accessory device port;
receiving, by the adapter via the accessory device port, second identity and status data from the second accessory device;
sending, by an electronic controller of the adapter having a wireless transceiver, the second identity and status data regarding the second accessory device to the peripheral device;
receiving, by the electronic controller, second settings data regarding the second accessory device from the peripheral device; and
providing, via the adapter, the second settings data to the second accessory device to control the second accessory device.
